# DEMANDE DE BREVET EUROPEEN

(11) **EP 1 326 345 A1**
(43) Date de publication de la demande: **09.07.2003**
(21) Numéro de dépôt: 02354196.4
(22) Date de dépôt: 20.12.2002
(51) Int. Cl.: H03M 13/29

(54) **Turbo-décodeur compact à haute efficacité**

(30) Priorité: 20.12.2001 FR 0116619
(71) Demandeur: STMicroelectronics S.A., 92120 Montrouge (FR)
(72) Inventeur: Mejean, Philippe, 38600 Fontaine (FR); Cambonie, Joel, 38190 La Combe de Lancey (FR)
(74) Mandataire: de Beaumont, Michel

(57) **Abrégé**

L'invention concerne un circuit et un procédé pour décoder des données codées par blocs à l'aide d'un turbo-code comprenant des étapes successives mettant en jeu des algorithmes différents. Au moins deux desdites étapes successives sont propres à être appliquées en parallèle à des blocs de données différents.

## Description

La présente invention concerne les codes de correction d'erreur, et en particulier le décodage de turbo-codes.

Les turbo-codes, d'introduction récente, font partie des codes de correction d'erreur. Les codes de correction d'erreur ont un effet technique et résolvent un problème technique important. En effet, ils permettent de restituer la valeur de bits erronés, par exemple à la suite d'un stockage ou d'une transmission. On peut même affirmer que, sans codes de correction d'erreur, tout stockage ou transmission d'informations numériques serait illusoire. Les turbo-codes sont des codes de correction d'erreur très efficaces.

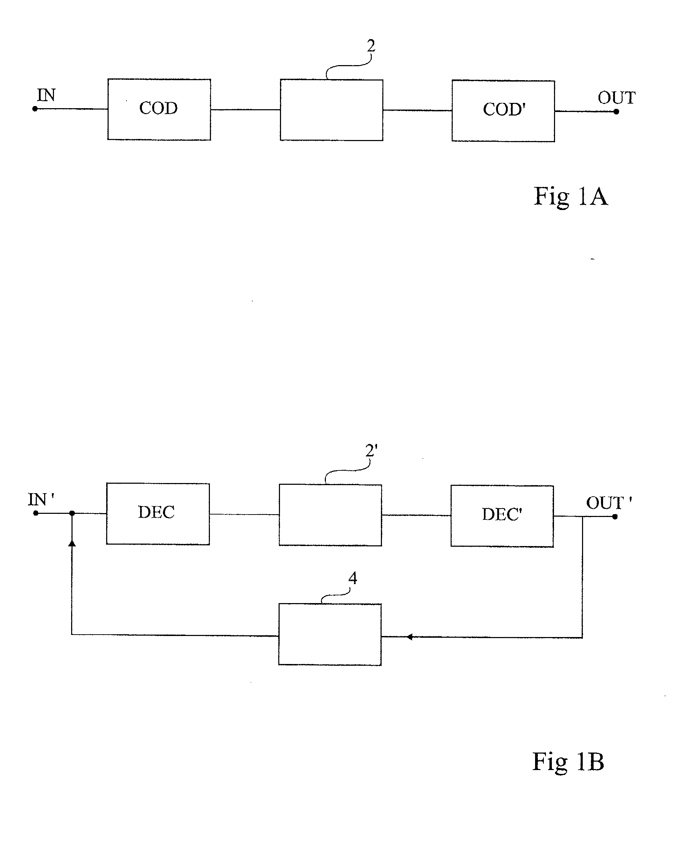

La figure 1A illustre le principe d'un turbo-codeur, aussi nommé codeur à turbo-codes. Sur une entrée IN, les données numérisées sous forme d'une suite de bits attaquent un codeur COD. Le codeur COD est un codeur simple qui calcule et affecte aux données un code de correction d'erreur sous forme de bits de redondance. Le codeur COD peut être de tout type connu, par exemple un codeur de type convolutif, BCH, BCH étendu, Reed Solomon, LDPC ("Low Density Parity Check" - "Contrôle de parité à basse densité"), etc.

La sortie du codeur COD attaque un brasseur 2 ("Interleaver" en anglais). Le brasseur 2 opère sur des blocs et fournit les données reçues d'un bloc dans un ordre différent. Le brasseur 2 attaque l'entrée d'un codeur COD'. Le codeur COD' est un codeur simple de même type que le codeur COD. Les données fournies par la sortie OUT du codeur COD' sont dites codées par turbo-codes et elles comprennent, outre les bits reçus en entrée, les bits de redondance fournis par les codeurs COD et COD'.

La figure 1B illustre le principe d'un turbo-décodeur, aussi nommé décodeur à turbo-codes. Sur une entrée IN', le turbo-décodeur reçoit des données provenant du codeur à turbo-codes, en général après stockage ou transmission. Les données à décoder attaquent un décodeur DEC. Le décodeur DEC réalise une fonction inverse de celle du codeur COD et il assure un premier décodage des données. La sortie du décodeur DEC attaque un brasseur 2' qui réalise la même opération de brassage que le brasseur 2. La sortie du brasseur 2' attaque un décodeur DEC'. Le décodeur DEC' réalise une fonction inverse de celle du codeur COD'. La sortie du décodeur DEC' est réinjectée à l'entrée IN' par l'intermédiaire d'un débrasseur 4 ("Deinterleaver" en anglais). Le débrasseur 4 réalise une fonction de débrassage inverse de la fonction réalisée par le brasseur 2'.

Le traitement réalisé par les éléments DEC, 2', DEC' et 4 sur un bloc de données d'entrée constitue une itération.

Les turbo-décodeurs réalisent plusieurs itérations à partir des mêmes données d'entrée, le nombre des erreurs corrigées étant d'autant plus grand que le nombre d'itérations est grand. Le nombre d'itérations réalisé dépend du BER souhaité ("Bit Error Rate" - "Taux d'erreurs de bits"). Une première demi-itération est réalisée par le décodeur DEC et le brasseur 2', et une deuxième demi-itération est réalisée par les éléments DEC' et 4. Lors d'une deuxième itération, les éléments DEC, 2', DEC', et 4 sont parcourus par les données issues de 4 lors de la première itération, le cas échéant après pondération et conjointement avec les données d'entrée du bloc originel.

Lors de la dernière itération, les données sont prélevées sur une sortie OUT', ici la sortie du décodeur DEC'.

Lorsque les codeurs COD et COD' sont des codeurs de type convolutif, les architectures des turbo-codeur et turbo-décodeur suivent d'assez près les schémas de principe des figures 1A et 1B.

Dans le cas où les données sont codées par exemple par des codages de type BCH, BCH étendu, Reed Solomon, les architectures des turbo-codeur et turbo-décodeur s'écartent quelque peu du schéma de principe.

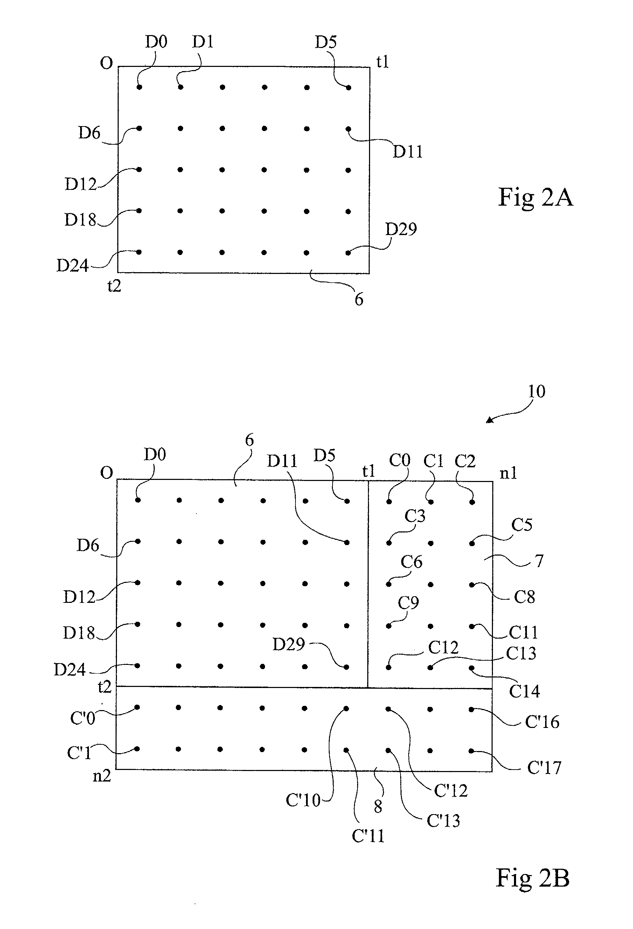

La figure 2A illustre un bloc de données destinées à être codées à l'aide de tels codes. Le bloc de données se présente sous la forme d'un tableau rectangulaire 6, comportant t2 lignes et t1 colonnes. Des données Di à coder, sous forme de bits, arrivent les unes après les autres et sont disposées dans le tableau 6 dans un ordre connu. En figure 2A, t1 = 6 et t2 = 5. Les données D0 à D5 remplissent la première ligne du tableau, les données D6 à D11 remplissent la deuxième ligne du tableau et les données D24 à D29 remplissent la dernière ligne du tableau. Le tableau 6 a la forme d'une matrice et peut être stocké dans une mémoire vive.

La figure 2B représente un tableau rectangulaire 10 illustrant le turbo-codage des données Di du bloc 6. Le tableau 10 comporte n2 lignes et n1 colonnes, avec n1 > t1 et n2 > t2. Le tableau 10 est formé de trois blocs. En haut à gauche, se trouve le bloc 6 des données Di. A droite du bloc 6, se trouve un bloc 7 comportant t2 lignes et (n1-t1) colonnes. Le bloc 7 renferme des codes Ci, sous forme de bits, résultant de l'application du codeur COD. Sous les blocs 6 et 7, se trouve un bloc 8 comportant (n2-t2) lignes et n1 colonnes. Le bloc 8 renferme des codes C'i, sous forme de bits, résultant de l'application du codeur COD'. En figure 2B, n1 = 9 et n2 = 7.

Les codes Ci sont obtenus en codant les données Di ligne par ligne à l'aide du codeur COD. Ainsi, le codage de la première ligne D0 à D5 du bloc 6 fournit trois codes C0, C1 et C2 qui forment la première ligne du bloc 7. La deuxième ligne du bloc 7 renferme les codes C3 à C5, résultant du codage des données D6 à D11 et la dernière ligne du bloc 7 renferme les codes C12, C13 et C14, correspondant au codage des données D24 à D29.

Lorsque le codage en ligne est terminé, on effectue le codage des colonnes des blocs 6 et 7 à l'aide du code COD' . La première colonne du bloc 6, correspondant aux données D0, D6, D12, D18 et D24, est codée à l'aide du code COD' et fournit deux codes C'0 et C'1, formant la première colonne du bloc 8. Il en est de même pour les colonnes suivantes du bloc 6. La dernière ligne du bloc 6, correspondant aux données D5, D11, D17, D23 et D29 fournit les codes C'10 et C'11 formant la sixième colonne du bloc 8.

Les colonnes suivantes du bloc 8 renferment des codes C'i résultant du codage des bits Ci par le codeur COD'. Ainsi, le codage de la première colonne du bloc 7, correspondant aux codes C0, C3, C6, C9 et C12, fournit les codes C'12 et C'13 formant la septième colonne du bloc 8. La dernière colonne du bloc 7, contenant les codes C2, C5, C8, C11 et C14 fournit, après codage par le codeur COD', les codes C'16 et C'17 formant la dernière colonne du bloc 8.

Dans le cas des figures 2A et 2B, le brassage est réalisé par le codage successif des données en lignes et en colonnes, et un circuit particulier de brassage n'est pas utile.

Les n1.n2 bits du bloc 10 sont envoyés par un moyen quelconque à un turbo-décodeur. Le décodage a lieu ligne par ligne puis colonne par colonne, une itération étant réalisée après un décodage complet du bloc 10. Plusieurs itérations sont réalisées, afin d'obtenir un taux d'erreurs souhaité.

Un problème général du turbo-décodage est sa lenteur. En effet, plusieurs itérations sont nécessaires pour obtenir le taux d'erreur souhaité. Ces itérations mettent en oeuvre des algorithmes compliqués et les étapes de traitement sont relativement longues. En outre, en transmission, les données doivent être traitées en temps réel par le turbo-décodeur, et avec une latence minimale. A partir d'un certain débit, le circuit qui a effectué la première itération sur un bloc de données ne peut pas réaliser les itérations suivantes, car les données qui arrivent entrent en collision avec les données en cours de traitement.

Une solution de l'art antérieur à ce problème est de disposer plusieurs turbo-décodeurs en série, chaque turbo-décodeur réalisant une itération. Il en résulte des circuits de turbo-décodage peu compacts.

Un objet de la présente invention est de prévoir un procédé de décodage de turbo-codes rapide.

Un autre objet de la présente invention est de prévoir un décodeur de turbo-codes compact.

Pour atteindre ces objets, la présente invention prévoit un procédé pour décoder des données codées par blocs à l'aide d'un turbo-code comprenant des étapes successives mettant en jeu des algorithmes différents. Au moins deux desdites étapes successives sont propres à être appliquées en parallèle à des blocs de données différents.

Selon un mode de réalisation de la présente invention, lesdites étapes successives comprennent une première étape pour calculer un syndrome et une deuxième étape de mise à jour utilisant le syndrome calculé au cours de la première étape.

Selon un mode de réalisation de la présente invention, la première étape est réalisée sur une première partie d'un premier bloc de données tandis que la deuxième étape est réalisée sur une deuxième partie dudit premier bloc ou sur une partie d'un deuxième bloc de données.

Selon un mode de réalisation de la présente invention, la première étape, ou étape de calcul du syndrome, met en jeu n premiers processeurs propres à opérer en parallèle sur n lignes, respectivement colonnes, d'un bloc et la deuxième étape, ou étape de mise à jour, met en jeu m deuxièmes processeurs propres à opérer en parallèle sur m lignes, respectivement colonnes, d'un bloc.

Selon un mode de réalisation de la présente invention, un bloc de données est de dimension 32 x 32 et n = m = 16.

Selon un mode de réalisation de la présente invention, les données sont codées par un codage de type BCH ou BCH étendu.

Selon un mode de réalisation de la présente invention, l'étape de mise à jour met en jeu un algorithme de Berlekamp ou un algorithme d'Euclide suivi d'un algorithme de Chase-Pyndiah.

La présente invention concerne aussi un circuit de décodage de données codées par blocs à l'aide d'un turbo-code. Le circuit comprend :
- un premier moyen pouvant calculer en parallèle n syndromes, chaque syndrome correspondant au syndrome d'une ligne, respectivement colonne, d'une première partie d'un premier bloc de données, et
- un deuxième moyen pouvant mettre à jour en parallèle m lignes, respectivement colonnes, d'une deuxième partie dudit premier bloc ou d'une partie d'un deuxième bloc de données.

Selon un mode de réalisation de la présente invention, le circuit comprend un troisième moyen propre à mémoriser au moins deux blocs de données successifs.

Selon un mode de réalisation de la présente invention, un bloc de données à décoder est de dimension 32 x 32 et n = m = 16.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A, précédemment décrite, illustre le principe d'un turbo-codeur ;
la figure 1B, précédemment décrite, illustre le principe d'un turbo-décodeur ;
la figure 2A, précédemment décrite, illustre la disposition de données codées par blocs ;
la figure 2B, précédemment décrite, illustre le principe du turbo-codage de données codées par blocs ;
les figures 3A à 3I illustrent un exemple de turbo-décodage selon la présente invention ; et
la figure 4 illustre un turbo-décodeur selon la présente invention.

Dans la présente invention, de même que dans l'art antérieur, un traitement de raccourcissement-poinçonnage ("shortening-puncturing" en anglais) peut avoir lieu. Le raccourcissement est une opération consistant à ne pas remplir tout le bloc 6 avec des données Di, des bits de remplissage étant insérés à la place des bits Di manquants. Pour ce faire, lorsque le bloc 6 est formé à l'aide des données d'entrée Di, certains emplacements du bloc 6 ne sont pas remplis par des données d'entrée et un zéro y est placé. L'emplacement des bits de remplissage est connu.

Les codeurs COD et COD' codent les données Di après l'opération de raccourcissement, c'est-à-dire qu'ils codent les lignes ou les colonnes du bloc 6 contenant les bits de remplissage.

Le poinçonnage consiste à ne transmettre qu'une partie des codes Ci et/ou C'i. L'emplacement des codes Ci et C'i non transmis est connu.

Les bits de remplissage ne sont pas transmis, de même que les codes "poinçonnés". Ainsi, les blocs transmis comportent un nombre réduit de bits, correspondant aux seules données d'entrée Di et aux codes Ci et C'i qui n'ont pas été poinçonnés.

La transmission peut avoir lieu par l'intermédiaire d'un canal quelconque. Il peut s'agir par exemple de transmission sans fil, de transmission sur un câble téléphonique ou un autre câble, etc.

La transmission modifie les bits transmis et leur rajoute une fonction f(t) qui, en théorie, peut prendre n'importe quelle valeur de -_{∞} à +_{∞}.

Dans un exemple classique de codage en vue de la transmission, intervenant après le turbo-codage, les bits transmis, "0" ou "1", sont codés avec une des deux valeurs "-1" et "+1" (par exemple, "-1" correspond à "0" et "+1" à "1"). Dans ce cas, les bits reçus ont une valeur égale à -1 + f(t) ou +1 + f(t), selon qu'un "0" ou un "1" a été transmis. Chaque bit reçu se présente ainsi sous la forme d'une grandeur analogique.

Dans le décodeur, la grandeur analogique reçue correspondant à chaque bit est quantifiée en un mot de M bits. Par exemple, dans une réalisation pratique du turbo-décodeur de la présente invention, les mots reçus sont représentés par des nombres signés de quatre bits, le premier bit correspondant au bit de signe (0 pour un mot positif et 1 pour mot négatif). Les mots reçus sont ainsi représentés par des valeurs allant, en numération décimale, de -8 à +7. Dans un tel mot, le signe correspond à ce que l'on pense être du bit transmis, et la valeur absolue du mot correspond à la confiance que l'on a dans le signe. Si la confiance est égale à 7 ou 8, on est pratiquement certain que le signe est exact. Par contre, si la confiance est voisine de 0, on est très peu certain de la valeur du signe.

En réception, le turbo-décodeur forme d'abord le bloc à décoder, à l'aide des mots reçus. Là où un zéro a été inséré dans le bloc 6, on place directement -7 dans le bloc à décoder car on est certain que le bit transmis était "0" ("-1"). Zéro est placé à l'emplacement des codes poinçonnés, car la valeur du code poinçonné est inconnue et l'on a autant de chances d'avoir poinçonné un "0" ou un "1".

A la fin de cette opération, le décodeur dispose d'un bloc à décoder comportant n2 lignes de n1 mots chacun.

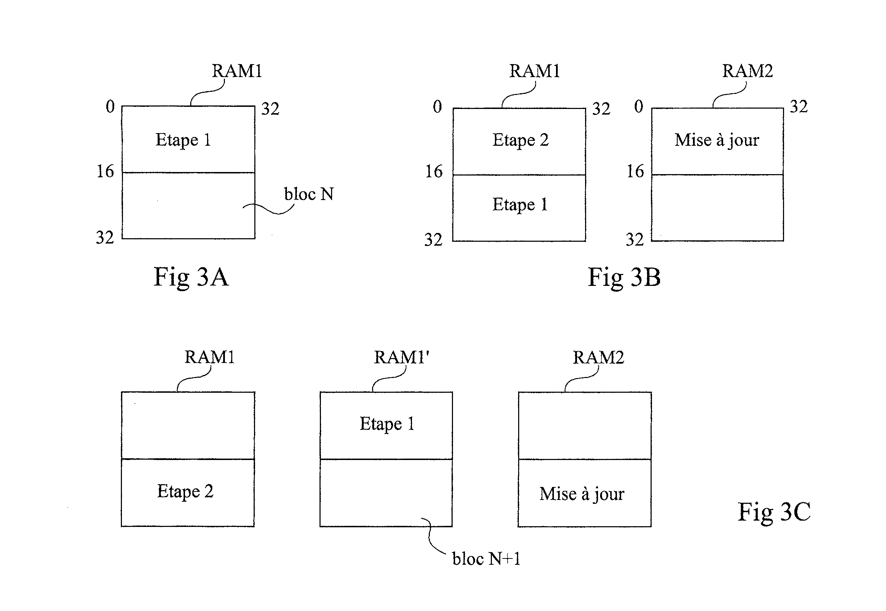

En figure 3A, les mots d'un bloc sont disposés dans une mémoire vive RAM1. Pour les besoins de la description, les paramètres n1 et n2 de la figure 2B ont été tous deux pris égaux à 32 et les paramètres t1 et t2 égaux à 24. La mémoire RAM1 peut ainsi être représentée sous la forme d'un tableau de dimension 32 par 32, un emplacement de la mémoire pouvant contenir un mot de quatre bits au moins.

Après le remplissage de la mémoire RAM1, on commence la première itération par un décodage ligne par ligne.

Le décodage d'une ligne (comme celui d'une colonne) comprend deux étapes successives. Une première étape correspond à un calcul de syndrome, à l'aide des mots de la ligne. Le calcul du syndrome, connu, peut être réalisé de toute manière appropriée et ne sera pas explicité ici. Il utilise les signes des mots.

La première étape est suivie d'une deuxième étape. La deuxième étape, que l'on peut appeler étape de décodage proprement dit ou de mise à jour, utilise le résultat de la première étape et met en jeu des algorithmes propres à fournir une nouvelle ligne dans laquelle des erreurs ont été corrigées. La nouvelle ligne, qui est le résultat de la première demi-itération, est en principe une représentation plus fidèle de la ligne émise que la ligne reçue. Si la nouvelle ligne comporte trop d'erreurs, celle-ci n'est pas utilisée et la ligne avant décodage est utilisée par la suite au lieu de la ligne décodée.

Dans l'exemple de réalisation mis en pratique, les codes sont des codes BCH ou BCH étendus, et la deuxième étape met en jeu un algorithme de Berlekamp (ou un algorithme d'Euclide), suivi d'un algorithme de Chase-Pyndiah. L'algorithme de Chase-Pyndiah a été choisi pour sa robustesse. Le résultat de l'application de l'algorithme de Chase-Pyndiah fournit les confiances des mots de la ligne, le cas échéant associées à de nouveaux signes. Les durées des première et seconde étapes sont de même ordre.

Dans l'art antérieur, les circuits existants utilisent deux processeurs, un pour le calcul du syndrome et un pour la mise à jour. Chacun des processeurs traite une ligne ou colonne à la fois. Il en résulte que le temps de traitement est long. Par exemple, si le temps d'une étape est égal à d pour une ligne, une demi-itération dure environ 48.d pour 24 lignes. En plus, comme les processeurs de l'art antérieur opèrent sur un même bloc, il faut attendre la fin d'une demi-itération pour débuter la deuxième, d'où une perte de temps supplémentaire.

Dans la présente invention, plusieurs processeurs, ayant chacun la capacité de traiter une ligne ou une colonne, sont utilisés en parallèle, tant lors de la première que de la deuxième étape. En outre, dans la présente invention, les processeurs peuvent opérer sur des blocs différents.

A priori, l'idée d'utiliser plusieurs processeurs en parallèle peut paraître simple. Cependant, la réalisation pratique de plusieurs processeurs de ce type dans un circuit intégré n'est pas simple à réaliser car ces processeurs occupent une grande surface. De plus, l'homme du métier considérait que la mise en parallèle de plusieurs de ces processeurs allait occuper une surface de silicium telle que le circuit n'était pas réalisable. Cependant, la demanderesse, en utilisant une technologie inférieure à 35 µm, a réalisé un circuit comportant 16 processeurs propres à calculer les syndromes de 16 lignes et/ou colonnes en parallèle, et 16 processeurs propres à réaliser l'étape de mise à jour sur 16 lignes et/ou colonnes en parallèle, avec une surface générale de circuit inférieure à 10 mm².

La mémoire RAM1 de la figure 3A contient les mots d'un bloc de rang N. Les 24 premiers mots des 24 premières lignes correspondent aux bits de données reçus. Les autres mots des 24 premières lignes correspondent aux codes Ci reçus. Les mots des huit dernières lignes de la mémoire RAM1 correspondent aux codes C'i reçus.

La figure 3A illustre une première phase du traitement. Au cours de la première phase, les 16 premières lignes de la mémoire RAM1 sont traitées en même temps par les 16 processeurs adaptés au calcul de syndrome, nommés par la suite premiers processeurs (étape 1). A l'issue de la première phase, un syndrome est obtenu pour chacune des 16 premières lignes. La durée de la première phase est sensiblement égale à d.

La figure 3B illustre une deuxième phase du traitement, faisant suite à la première phase. En figure 3B, sont représentées la mémoire RAM1 et une mémoire vive RAM2, également de dimension 32 x 32.

Au cours de la deuxième phase, deux opérations sont effectuées.

D'une part, les 16 premiers processeurs calculent le syndrome des lignes de rang 17 à 32 (la première ligne est la ligne de rang 1). Même si seules les lignes de rang 17 à 24 correspondent à un codage par le codeur COD, un décodage de toutes les lignes de la matrice peut être effectué. En effet, les codes C'i issus du codage des codes Ci forment avec les codes C'i issu du codage des données Di des lignes pouvant être décodées de la même façon que les autres lignes de la matrice. On peut aussi, dans une variante de réalisation, ne décoder que les lignes correspondant à un codage par le codeur COD.

D'autre part, pendant ce temps, les 16 autres processeurs, dits seconds processeurs, disposant des syndromes des 16 premières lignes, réalisent le décodage proprement dit des 16 premières lignes de la mémoire RAM1 (étape 2). Le résultat du décodage, aussi appelé mise à jour, est stocké, après pondération par un coefficient p, dans la mémoire RAM2, faisant office de mémoire de travail. Le coefficient p est un coefficient compris entre zéro et un. Le coefficient p augmente avec le numéro de l'itération. Par exemple, pour la première itération, le coefficient de pondération p est égal à 0,4 et, pour la quatrième itération, p est égal à 0,5.

La figure 3C illustre une troisième phase de traitement, faisant suite à la deuxième phase. En figure 3C, sont représentées la mémoire RAM1, la mémoire RAM2 et une mémoire vive RAM1', également de dimension 32 x 32. La mémoire RAM1' est prévue pour stocker - après d'éventuelles opérations de restauration faisant suite à un raccourcissement et/ou poinçonnage - un bloc N+1 arrivant après le bloc N.

Au cours de la troisième phase, deux opérations sont aussi effectuées.

D'une part, l'étape de mise à jour (étape 2) est réalisée sur les lignes de rang 17 à 32 du bloc N, contenu dans la mémoire RAM1. Le réajustement ou mise à jour de ces lignes est stocké dans les lignes 17 à 32 de la mémoire RAM2. Ainsi, à la fin de la troisième phase, la mémoire RAM2 comporte l'ensemble des lignes 1 à 32 du bloc N, mises à jour. La première demi-itération est donc terminée à l'issue de la troisième phase.

D'autre part, la mémoire RAM1', qui contient le bloc N+1, est utilisée pour le calcul du syndrome de ses 16 premières lignes (étape 1). Le fait, selon la présente invention, de traiter des blocs différents en parallèle lorsque les premiers et seconds processeurs ne sont pas utilisés ensemble sur un même bloc va permettre un gain de temps considérable. Cet avantage, allié à celui procuré par la présence de plusieurs processeurs d'un même type en parallèle, améliore de façon très importante les performances du turbo-décodage.

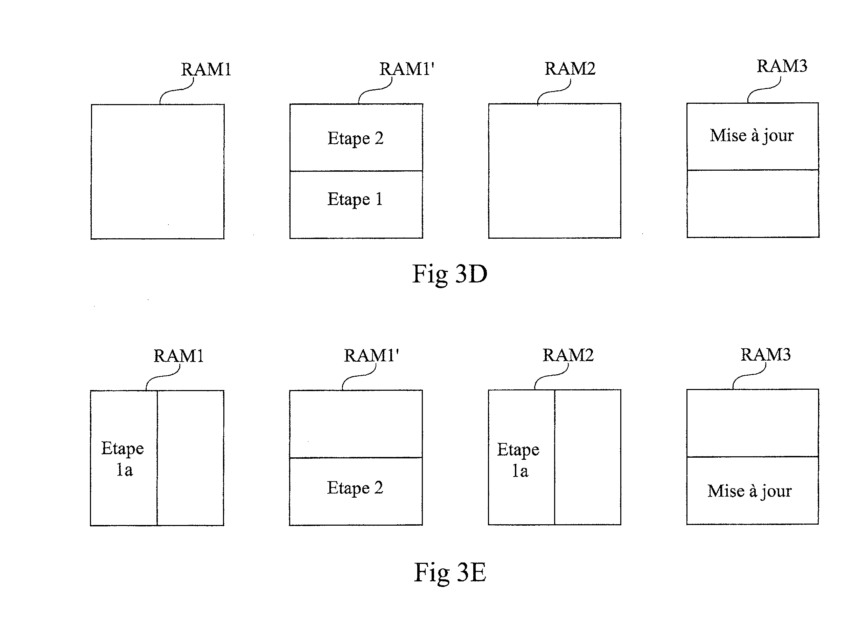

La figure 3D illustre une quatrième phase du traitement. En figure 3D, sont représentées la mémoire RAM1, la mémoire RAM2, la mémoire RAM1' et une mémoire vive RAM3, également de dimension 32 x 32.

Au cours de la quatrième phase, les deux groupes de processeurs agissent tous deux sur le bloc N+1, contenu dans la mémoire RAM1'. Le premier groupe de processeurs réalise le calcul du syndrome des lignes de rang 17 à 32 de la mémoire RAM1'. Le deuxième groupe de processeurs réalise le décodage proprement dit des 16 premières lignes de la mémoire RAM1'. Lorsque le décodage des 16 premières lignes de la mémoire RAM1' est terminé, les lignes réajustées sont stockées dans la mémoire RAM3.

La figure 3E illustre une cinquième phase du traitement. Au cours de cette phase, le décodage des lignes du bloc N étant terminé, la deuxième demi-itération peut commencer. Pour ce faire, les 16 premiers processeurs agissent sur les 16 premières colonnes de la mémoire RAM2 et de la mémoire RAM1. En effet, les premiers processeurs agissent sur des colonnes formées d'une somme des colonnes du bloc N originel, contenu dans la mémoire RAM1, et des colonnes du bloc N après la première demi-itération, contenu dans la mémoire RAM2. Cela est symbolisé en figure 3E par l'indication "étape 1a" au niveau des 16 premières colonnes des mémoires RAM1 et RAM2.

En outre, au cours de la cinquième phase, les 16 seconds processeurs agissent sur la mémoire RAM1' et réalisent le décodage des lignes de rang 17 à 32. Les lignes réajustées sont stockées dans la mémoire RAM3. A la fin de la cinquième phase, la mémoire RAM3 renferme ainsi les lignes de rang 1 à 32 du bloc N+1, mises à jour. Les colonnes du bloc N+1 peuvent donc désormais être traitées.

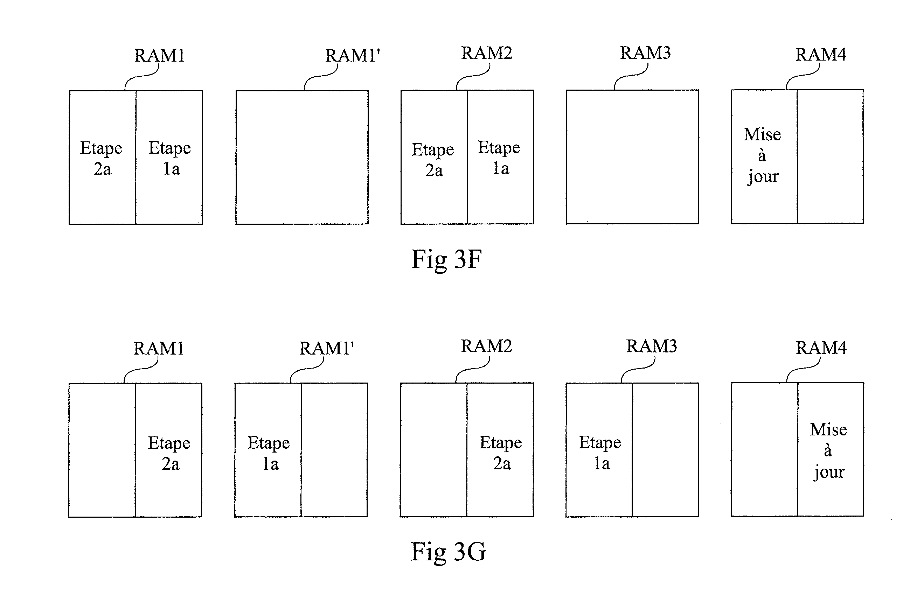

La figure 3F illustre une sixième phase du traitement. En figure 3F, sont représentées les mémoires RAM1, RAM1', RAM2, RAM3, ainsi qu'une mémoire vive RAM4, de dimension 32 x 32. Les premiers et seconds processeurs utilisent tous deux les colonnes des mémoires RAM1 et RAM2. Les seconds processeurs réalisent le décodage proprement dit des colonnes utilisées pour le calcul des syndromes calculés au cours de la cinquième phase, élaborées à partir des 16 premières colonnes des mémoires RAM1 et RAM2. Cela est indiqué par la mention "étape 2a" en figure 3F. Le résultat du décodage est stocké dans la mémoire RAM4. Les premiers processeurs réalisent la première étape de la deuxième demi-itération du bloc N, à savoir le calcul du syndrome de 16 colonnes formées d'une somme des 16 dernières colonnes des mémoires RAM1 et RAM2.

La figure 3G illustre une septième phase du traitement. Au cours de la septième phase, les seconds processeurs agissent sur les mémoires RAM1 et RAM2, pour effectuer le décodage des 16 dernières colonnes. Le résultat du décodage est stocké dans la mémoire RAM4. A la fin de la septième phase de traitement, la mémoire RAM4 contient ainsi le bloc N mis à jour après la première itération. En outre, au cours de la septième phase, les premiers processeurs calculent, en vue de la deuxième demi-itération du bloc N+1, le syndrome de colonnes de rang 1 à 16 à l'aide du contenu des mémoires RAM1' et RAM3.

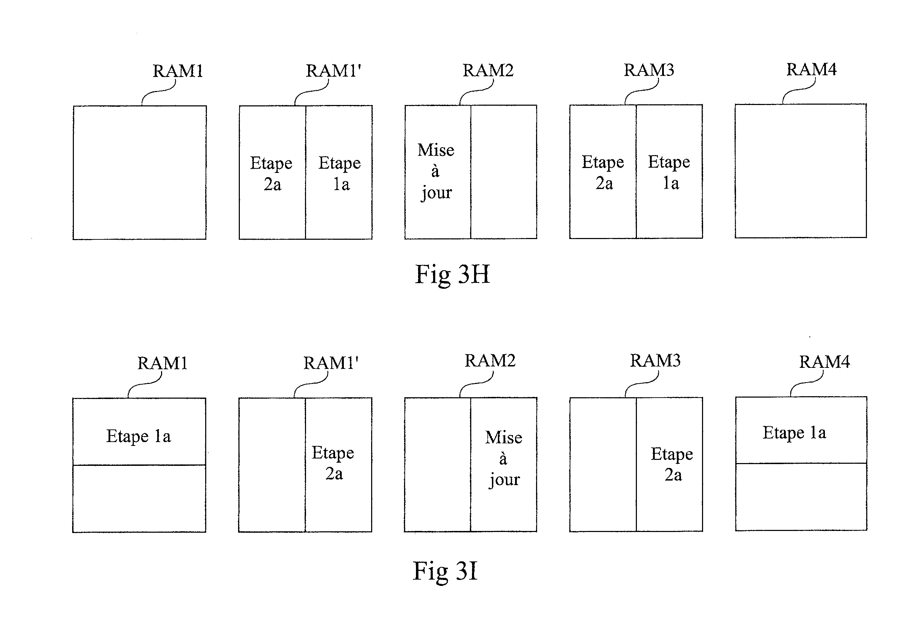

La figure 3H illustre une huitième phase du traitement. Au cours de la huitième phase, les premiers et seconds processeurs agissent tous deux sur les mémoires RAM1' et RAM3 (bloc N+1). Les seconds processeurs décodent les colonnes de rang 1 à 16. Le résultat du décodage, à savoir la mise à jour des 16 premières colonnes du bloc N+1, est stocké dans les 16 premières colonnes de la mémoire RAM2, à la place des résultats intermédiaires concernant le bloc N qui s'y trouvent et qui sont désormais inutiles. Les premiers processeurs calculent les syndromes des 16 dernières colonnes du bloc N+1.

La figure 3I illustre une neuvième phase du traitement, correspondant à la première phase de traitement comme on va le voir. Au cours de la neuvième phase, les 16 dernières colonnes du bloc N+1 sont décodées par les seconds processeurs, et le résultat du décodage est stocké dans les 16 dernières colonnes de la mémoire RAM2, remplaçant les résultats intermédiaires qui s'y trouvent. A l'issue de la neuvième phase, la mémoire RAM2 contient ainsi le bloc N+1, réajusté après la première itération. En outre, les premiers processeurs calculent les syndromes des 16 premières lignes du bloc N en vue de la deuxième itération. Pour ce faire, comme pour toutes les itérations qui suivent, les premiers processeurs opèrent sur la somme des lignes contenues dans la mémoire RAM1, correspondant au bloc N originel, et des lignes correspondantes obtenues après l'itération qui vient de s'achever. Ici, la somme des lignes contenues dans les mémoires RAM1 et RAM4 est effectuée en vue d'alimenter les premiers processeurs.

La neuvième phase correspond à la première phase, seule la mémoire RAM1 ayant été considérée en figure 3A pour la clarté de l'exposé. Après la neuvième phase, la phase suivante correspond à la phase décrite en relation avec la figure 3B.

Une itération complète pour deux blocs a donc été effectuée en huit phases, d'une durée totale sensiblement égale à 8d. Ces chiffres sont à comparer à ceux de l'art antérieur, où une itération dure 48d par bloc, soit 96d pour deux blocs. Grâce à la rapidité du turbo-décodage selon la présente invention, un seul circuit de turbo-décodage peut effectuer toutes les itérations requises en temps réel, même à des débits élevés. Il en résulte des turbo-décodeurs compacts.

On notera que le procédé de turbo-décodage décrit en relation avec les figures 2A, 2B, 3A à 3I est un exemple seulement pouvant comporter de nombreuses modifications à la portée de l'homme de l'art. En particulier, l'ordre des phases, de même que les opérations menées lors d'une phase particulière, peuvent être modifiées sans sortir du domaine de la présente invention.

Par exemple, lors de la première phase, les premiers processeurs peuvent calculer les syndromes des lignes de rang 17 à 32, au lieu des syndromes des seize premières lignes de la mémoire RAM1, les modifications ultérieures étant à la portée de l'homme de l'art. Par exemple, avec la modification ci-dessus, la première étape de la deuxième phase (figure 3B) doit alors être réalisée sur les seize premières lignes, tandis que la deuxième étape est effectuée sur les lignes de rang 17 à 32.

On notera que, pour toute itération, le décodage des colonnes est réalisé, non seulement à l'aide des lignes mises à jour lors de la première demi-itération de l'itération, mais aussi à l'aide des lignes du bloc originel. Le décodage des colonnes peut être réalisé à l'aide de la somme des lignes du bloc originel et des lignes mises à jour lors de la demi-itération précédente, comme cela a été décrit, ou à l'aide d'une combinaison linéaire quelconque appropriée de ces lignes.

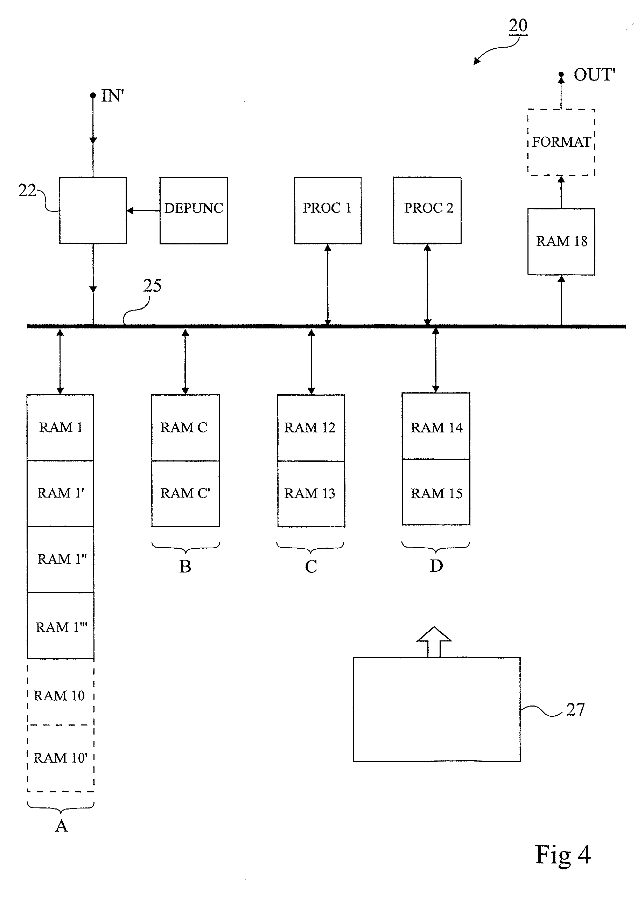

On va maintenant décrire un exemple de circuit de turbo-décodage 20 en relation avec la figure 4. Le circuit 20 permet la réalisation de quatre itérations successives en temps réel, pour des débits allant jusqu'à 54 Mbit/s, avec des blocs de dimension 32 x 32.

Le circuit de turbo-décodage 20 comporte une entrée IN' et une sortie OUT'. L'entrée IN' du circuit 20 reçoit les mots analogiques reçus, correspondant aux bits transmis, ici avec les valeurs -1 et +1. Un bloc de traitement 22 est couplé à l'entrée IN'. Le bloc 22 code sur quatre bits les mots reçus et les range dans un tableau de dimension 32 par 32, correspondant au bloc à décoder. Un module DEPUNC, relié au bloc 22, permet d'effectuer les opérations inverses du raccourcissement et du poinçonnage. Pour ce faire, le module DEPUNC fournit les emplacements du bloc où des zéros ont été insérés dans les données, ainsi que les emplacements où des bits de redondance Ci et C'i ont été poinçonnés. La sortie du bloc 22 alimente un bus 25. Le bus 25 est un bus pouvant transporter en parallèle des mots de 5 bits, correspondant aux quatre bits des mots originels plus à un éventuel bit de débordement dû aux divers calculs effectués par la suite. Au bus 25, sont reliés divers groupes de mémoires vives, ainsi que 16 premiers processeurs PROC1 et 16 deuxièmes processeurs PROC2. Les processeurs PROC1 permettent la réalisation de la première étape du décodage (calcul de syndrome) et les processeurs PROC2 permettent la réalisation de la deuxième étape (décodage proprement dit ou mise à jour). L'écriture et la lecture des diverses mémoires, ainsi que la commande des premiers et deuxièmes processeurs sont effectués par un contrôleur 27.

En figure 4, un premier groupe de mémoires, A, comprend deux mémoires RAM1 et RAM1', de dimension 32x32. Ces mémoires correspondent aux mémoires de même désignation décrites en relation avec le procédé relatif aux figures 3A à 3I, et sont chargées de stocker respectivement les blocs N et N+1. Le premier groupe de mémoires comprend en outre des mémoires vives RAM1" et RAM1"', toutes deux de dimension 32x32. Les mémoires RAM1" et RAM1"' sont prévues pour stocker respectivement les blocs N+2 et N+3 lors de leur arrivée. Ainsi, lorsque le traitement des blocs N et N+1 est terminé, les mémoires RAM1" et RAM1"' contiennent les blocs N+2 et N+3, et le traitement n'est pas interrompu.

Le groupe de mémoires A comprend également deux mémoires vives RAM10 et RAM10'. Les mémoires RAM10 et RAM10' ont chacune la capacité de stocker un bloc et sont facultatives. Comme on le verra par la suite, les mémoires RAM10 et RAM10' sont utilisées dans le cas où deux circuits 20 sont couplés en série, afin de réaliser un nombre d'itérations pouvant aller jusqu'à 8.

Bien entendu, chaque mémoire du groupe A possède un accès direct au bus 25 et peut être écrite ou lue indépendamment des autres sous le contrôle du contrôleur 27.

Un deuxième groupe de mémoires, B, comprend deux mémoires vives RAM C et RAM C', toutes deux ayant la capacité de contenir un bloc. Le circuit 20 comprend les mémoires RAM C et C' car les mémoires du groupe A sont des mémoires vives classiques, permettant une lecture ou une écriture dans une direction seulement. Dans l'exemple décrit, les mémoires RAM1 et RAM1' sont accessibles suivant les lignes des blocs qu'elles renferment. Les mémoires RAM C et RAM C' renferment respectivement les mots des blocs N et N+1 disposés de sorte que l'accès aux blocs puisse se faire selon les colonnes. Bien entendu, si le circuit utilise des mémoires RAM1, RAM1', RAM1" et RAM1"' permettant à la fois une lecture selon les lignes et les colonnes, les mémoires RAM C et RAM C' sont inutiles et peuvent être supprimées.

Un troisième groupe de mémoires, C, comprend deux mémoires vives, notées RAM12 et RAM13. Les mémoires RAM12 et RAM13 ont chacune la capacité de stocker un bloc. Ce sont des mémoires de travail.

Un quatrième groupe de mémoires, D, comprend deux mémoires vives, notées RAM14 et RAM15. Les mémoires RAM14 et RAM15 ont chacune la capacité de stocker un bloc. Elles peuvent servir de mémoires de travail ou de mémoires tampon (buffer) de sortie.

Comme pour le groupe A, chacune des mémoires des groupes B, C et D ont un accès direct au bus 25.

Le circuit 20 comprend en outre une mémoire vive RAM18 propre à stocker un bloc après traitement en vue de son envoi à d'autres circuits. La mémoire RAM18 peut être suivie d'un module FORMAT, optionnel, qui sera détaillé par la suite.

On va maintenant décrire le fonctionnement du circuit 20 en relation avec les figures 3A à 3I.

Lors de la première phase de traitement (voir la figure 3A), les seize premières lignes du bloc N, contenues dans la mémoire RAM1, sont transmises par le bus 25 aux processeurs PROC1. Les processeurs PROC1 calculent les syndromes des 16 premières lignes, et le résultat du calcul est transmis aux processeurs PROC2 en vue de l'étape de décodage proprement dit (deuxième phase, figure 3B). La mise à jour des 16 premières lignes du bloc N, c'est-à-dire les 16 premières lignes après la première demi-itération, sont stockées dans la mémoire RAM12. Par mise à jour, on entend, comme cela a été dit, le résultat du décodage proprement dit multiplié par un coefficient compris entre zéro et un, coefficient qui augmente avec le numéro de l'itération. Pendant ce temps, les processeurs PROC1 calculent le syndrome des lignes de rang 17 à 32 du bloc N.

Lors de la troisième phase (figure 3C), les lignes de rang 17 à 32 du bloc N sont décodées et la mise à jour de ces lignes est stockée dans la mémoire RAM12 qui, à l'issue de la troisième phase, contient l'ensemble des lignes du bloc N après la première demi-itération. Lors de cette phase, sont calculés les syndromes des 16 premières lignes du bloc N+1, contenu dans la mémoire RAM1. A chaque première demi-itération de chaque bloc, les lignes de RAM1 (respectivement RAM1') sont stockées dans la mémoire RAMC (respectivement RAMC').

Pour la deuxième demi-itération concernant le bloc N, qui a lieu au cours de la cinquième phase (figure 3E), comme le bloc originel doit être lu en colonnes, les mémoires RAM C et RAM12 sont utilisées. La mise à jour des colonnes du bloc N (figures 3F et 3G) est stockée dans la mémoire RAM14, pouvant être lue selon les lignes.

Les quatre mémoires RAM12, RAM13, RAM14 et RAM15 peuvent être considérées comme des mémoires de travail faisant office des mémoires RAM2, RAM3 et RAM4 utilisées lors de la description du procédé en relation avec les figures 3A à 3I.

Lorsque les quatre itérations d'un bloc sont terminées, le bloc traité est stocké dans la mémoire RAM18 en vue de sa fourniture par la sortie OUT'. Le cas échéant, le bloc traité transite par le module FORMAT, reliant la mémoire RAM18 à la sortie OUT'. Le module FORMAT a pour fonction de mettre le bloc fourni sous une forme accessible au circuit extérieur. Par exemple, le module FORMAT ne fournit que les données utiles après décodage D'i, c'est-à-dire sans les codes de redondance et sans les zéros additionnels de remplissage qui ont été introduits lors du codage.

Le circuit 20 permet, en un seul circuit intégré, de réaliser quatre itérations en temps réel à des débits relativement élevés. Si un nombre plus important d'itérations est souhaité, un premier circuit 20 peut être mis en série avec un deuxième circuit 20, ce qui permet de réaliser 8 itérations. Le deuxième circuit 20 utilise les mémoires RAM10, RAM10'. En effet, le deuxième circuit 20, pour les itérations 5 à 8 du bloc N, a besoin du bloc N originel et du bloc N mis à jour après la quatrième itération. Deux mémoires d'entrée à lecture en lignes (RAM1 et RAM10) sont ainsi nécessaires pour le bloc N. La mémoire RAM10' correspond à la mémoire RAM10, mais est utilisée pour le bloc N+1.

Bien entendu, la présente invention est susceptible de diverses variantes et modifications qui apparaîtront à l'homme de l'art. En particulier, le circuit de turbo-décodage pourra présenter d'autres éléments que ceux représentés en figure 4. Par exemple, une partie ou l'ensemble des mémoires décrites peut faire partie d'une seule mémoire de capacité suffisante.

Le module FORMAT peut être totalement absent ou faire partie d'un circuit extérieur. De même, le bloc de traitement 22 et le module DEPUNC peuvent être extérieurs au circuit.

Les paramètres t1 et t2 peuvent ne pas être égaux et prendre d'autres valeurs que celle décrite dans les exemples. Aussi, les paramètres n1 et n2 peuvent ne pas être égaux. De façon générale, le circuit 20 peut être adapté à des valeurs particulières des paramètres t1, t2, n1 et n2, fournies au circuit de turbo-décodage pour une utilisation particulière, une logique quelconque permettant d'adapter le fonctionnement du circuit au cas particulier choisi.

Le nombre d'itérations (de 1 à 4 pour un circuit, pouvant aller jusqu'à 8 pour deux circuits en série) peut être choisi en fonction de l'utilisation. Le nombre d'itérations choisi peut être différent d'un nombre entier, le résultat du décodage pouvant être fourni après un nombre entier de demi-itérations.

Le nombre des premiers ou des seconds processeurs en parallèle peut être différent de la valeur choisie dans les exemples décrits. De façon générale, le nombre des premiers processeurs en parallèle est égal à n et le nombre des seconds processeurs en parallèle est égal à m, n et m étant des nombres pouvant être différents.

L'invention n'est pas limitée au turbo-décodage de données codées par codage BCH ou BCH étendu, mais est applicable à tout turbo-décodage de données codées par blocs.

Les blocs traités en même temps peuvent être consécutifs ou non. Par exemple le bloc N et le bloc N+2 peuvent être traités en même temps tandis que les blocs N+1 et N+3 sont traités ensemble. Plus de deux blocs peuvent aussi être traités en même temps. De façon générale, selon la présente invention, si un turbo-décodage nécessite y étapes indépendantes, ces y étapes peuvent être, si besoin est, réalisées en même temps sur y blocs différents.

Aussi, l'invention a été décrite dans le cadre de la transmission de données. L'invention s'applique bien entendu à d'autres applications, comme le stockage des données, par exemple sur CD ROM ou disque dur.

## Revendications

1. Procédé pour décoder des données codées par blocs à l'aide d'un turbo-code comprenant des étapes successives mettant en jeu des algorithmes différents, **caractérisé en ce qu'**au moins deux desdites étapes successives sont propres à être appliquées en parallèle à des blocs de données différents.

2. Procédé selon la revendication 1, dans lequel lesdites étapes successives comprennent une première étape pour calculer un syndrome et une deuxième étape de mise à jour utilisant le syndrome calculé au cours de la première étape.

3. Procédé selon la revendication 2, dans lequel la première étape est réalisée sur une première partie d'un premier bloc de données tandis que la deuxième étape est réalisée sur une deuxième partie dudit premier bloc ou sur une partie d'un deuxième bloc de données.

4. Procédé selon la revendication 2 ou 3, dans lequel la première étape, ou étape de calcul du syndrome, met en jeu n premiers processeurs propres à opérer en parallèle sur n lignes, respectivement colonnes, d'un bloc et la deuxième étape, ou étape de mise à jour, met en jeu m deuxièmes processeurs propres à opérer en parallèle sur m lignes, respectivement colonnes, d'un bloc.

5. Procédé selon la revendication 4, dans lequel un bloc de données est de dimension 32 x 32 et dans lequel n = m = 16.

6. Procédé selon l'une quelconque des revendications 1 à 5, dans lequel les données sont codées par un codage de type BCH ou BCH étendu.

7. Procédé selon la revendication 6, dans lequel l'étape de mise à jour met en jeu un algorithme de Berlekamp ou un algorithme d'Euclide suivi d'un algorithme de Chase-Pyndiah.

8. Circuit de décodage (20) de données codées par blocs à l'aide d'un turbo-code, **caractérisé en ce qu'**il comprend :
- un premier moyen (PROC1) pouvant calculer en parallèle n syndromes, chaque syndrome correspondant au syndrome d'une ligne, respectivement colonne, d'une première partie d'un premier bloc de données, et
- un deuxième moyen (PROC2) pouvant mettre à jour en parallèle m lignes, respectivement colonnes, d'une deuxième partie dudit premier bloc ou d'une partie d'un deuxième bloc de données.

9. Circuit selon la revendication 8, comprenant un troisième moyen (RAM1, RAM1', RAM1", RAM1"') propre à mémoriser au moins deux blocs de données successifs.

10. Circuit selon la revendication 8 ou 9, dans lequel un bloc de données à décoder est de dimension 32 x 32 et dans lequel n = m = 16.
